# EUROPEAN PATENT APPLICATION

(11) **EP 2 234 463 A1**
(43) Date of publication of application: **29.09.2010**
(21) Application number: 08867594.7
(22) Date of filing: 19.12.2008
(51) Int. Cl.: H05H 1/46, H01L 21/205

(54) **PLASMA TREATMENT APPARATUS, HEATING DEVICE FOR THE PLASMA TREATMENT APPARATUS, AND PLASMA TREATMENT METHOD**

(30) Priority: 27.12.2007 JP 2007337153
(71) Applicant: Sharp Kabushiki Kaisha, Osaka-shi Osaka 545-8522 (JP)
(72) Inventor: KISHIMOTO, Katsushi, Osaka-shi, Osaka 545-8522 (JP); FUKUOKA, Yusuke, Osaka-shi, Osaka 545-8522 (JP)
(74) Representative: Müller - Hoffmann & Partner
(86) International application number: PCT/JP2008/073224
(87) International publication number: WO 2009/084486

(57) **Abstract**

To provide a plasma processing apparatus having relatively a reduced manufacturing cost, and excellent in a heating efficiency and a cooling efficiency.

An anode electrode 7 has provided therein tubular heating sections 31, ... 31 for heating an object (including a tray 5 and a substrate 6) to be plasma-processed. The tubular heating sections 31, ... 31 include seven tubular heaters (here, a sheath heater) 31, ... 31 that are U-shaped in plan configuration , and are arranged to be adjacent to each other in parallel. Tubular cooling sections 32, ... 32 for cooling the anode electrode 7 are also provided in the anode electrode 7. The cooling sections 32, ... 32 include seven cooling pipes (here, a cooling nitrogen gas-passing pipe) 32, ... 32 that are U-shaped in plan configuration , are arranged to be adjacent to each other in parallel along the outer side of the corresponding tubular heater 31, ... 31, and can exhaust a cooling gas, which is introduced into the inside and passes through the cooling pipes, to the outside.

## Description

### TECHNICAL FIELD

The present invention relates to a plasma processing apparatus, a heating device for a plasma processing apparatus, and a plasma processing method, and more particularly to a plasma processing apparatus for performing a plasma process onto a surface of a plate-like object by utilizing a vacuum chamber, a heating device used for the plasma processing apparatus of this type, and a plasma processing method by the plasma processing apparatus of this type.

### BACKGROUND ART

When a plasma process is performed onto a surface of a substrate, which is a plate-like object, a plasma processing apparatus utilizing a vacuum chamber is generally employed. The plasma processing apparatus described above is generally provided with a vacuum chamber in which a reaction for the plasma process is performed, at least a pair of plasma processing electrodes arranged in the vacuum chamber so as to be opposite to each other, a heating section for heating the substrate, and a cooling section for cooling the plasma processing electrodes that are heated by the heating section.

As a heating device that is applied to bake a wafer or a substrate during a baking process and a film-forming process of a semiconductor and a liquid crystal panel, and that has a cooling function, the one disclosed in Patent Document 1 has been known, for example.
Patent Document 1: Japanese Unexamined Patent Publication No. H9-260029

The heating device disclosed in the Patent Document 1 and having a cooling function includes a base plate, and a face plate mounted on one surface of the base plate. The base plate has a first channel formed on the one surface and a second channel formed on the other surface that is reverse to the one surface. A cooling pipe is embedded into the first channel, while a sheath heater is embedded into the second channel. The cooling pipe has a contact surface that is formed at the same height as the one surface of the base plate and that is exposed toward the one surface. The contact surface is in contact with the one surface of the face plate that is opposite to the one surface of the base plate.

The heating device thus configured and having the cooling function has the sheath heater and the cooling pipe respectively embedded into two channels formed on both of front and back surfaces of the base plate, wherein a part of the cooling pipe is in contact with the face plate, whereby it is described that a heating speed and a cooling speed in a heating process or a cooling process of a semiconductor during the baking process and the film-forming process can be enhanced.

### DISCLOSURE OF THE INVENTION

### PROBLEMS THAT THE INVENTION IS TO SOLVE

However, when the heating device thus configured and having the cooling function is applied to the plasma processing apparatus, problems described below arise.

Specifically, when the heating device is applied to the plasma processing apparatus in such a manner that the sheath heater of the heating device thus configured and having the cooling function is applied to a plasma processing electrode as a heating section for heating a substrate in the plasma processing apparatus, and the cooling pipe of the heating device is applied to the plasma processing electrode as a cooling section for cooling the plasma processing electrode that is heated by the heating section in the plasma processing apparatus, this structure means that the heating section and the cooling section are formed in the channels on both of the front and back surfaces of the electrode.

Therefore, before the heating section and the cooling section are formed, channels have to be formed on both surfaces of the electrode, and further, the thickness of the electrode in a certain amount should be secured in order to form the channels on both surfaces of the electrode, with the result that a manufacturing cost of the plasma processing apparatus increases.

When the plasma process is performed with the substrate being mounted on a front surface of the electrode in case where the heating section is formed on the front surface of the electrode and the cooling section is formed on a back surface of the electrode, the heating of the substrate is efficiently done by the heating section, but the cooling efficiency for cooling the electrode having relatively a large thickness might be reduced, because the cooling section is formed on the back surface of the electrode.

The present invention is accomplished in view of the above-mentioned circumstance. An object thereof is to provide a plasma processing apparatus having a relatively reduced manufacturing cost and excellent in a heating efficiency and a cooling efficiency, a heating device used for the plasma processing apparatus of this type, and a plasma processing method by the plasma processing apparatus of this type.

### MEANS OF SOLVING THE PROBLEMS

According to one aspect of the present invention, there is provided a plasma processing apparatus comprising a vacuum chamber in which a reaction for a plasma process is executed, a gas introducing section for introducing a plasma processing reaction gas into the vacuum chamber, a gas exhausting section for exhausting the reaction gas from the vacuum chamber, and at least a pair of plasma processing electrodes provided so as to be opposite to each other in the vacuum chamber, the plasma processing apparatus further comprising a tubular heating section that is provided at an inside or on a surface of one of the electrodes for heating an object, which is to be plasma-processed, and a tubular cooling section that is provided at the inside or on the surface of the electrode for cooling the electrode, wherein the heating section and the cooling section are arranged on the same plane.

In the plasma processing apparatus according to one aspect of the present invention, the vacuum chamber in which the reaction necessary for the plasma process is performed may have a structure that can be closed, and may be capable of withstanding a predetermined atmospheric pressure and temperature, and there is no special limitation on its shape and material. The gas introducing section introduces a plasma processing reaction gas into the vacuum chamber where the reaction necessary for the plasma process is performed. The gas exhausting section exhausts the reaction gas from the vacuum chamber where the reaction necessary for the plasma process is performed.

At least a pair of plasma processing electrodes (an anode electrode and a cathode electrode) is provided so as to be opposite to each other in the vacuum chamber where the reaction necessary for the plasma process is performed. According to need, plural pairs of the electrodes may be provided in such a manner that the electrodes oppose to each other in a vertical direction, in a longitudinal direction, or in a horizontal direction.

The tubular heating section for heating an object to be plasma-processed, e.g., a tray placed on the electrode and a plasma processing substrate placed onto the tray, is provided on the inner part or on the front surface of one of the anode electrode and the cathode electrode. The tubular cooling section for cooling the electrode is provided in the electrode or on the front surface of the electrode. The heating section and the cooling section are provided on the same plane.

The heating section includes, for example, plural tubular heaters that are U-shaped in plan configuration, and are arranged to be adjacent to each other in parallel. The cooling section includes, for example, plural tubular cooling pipes that are U-shaped in plan configuration, and are arranged to be adjacent to each other in parallel along the outer side or the inner side of the corresponding tubular heaters, and can exhaust a cooling gas, which is introduced into the inside and passes through the cooling pipes, to the outside. When the heating section and the cooling section include the tubular heater and the cooling pipe described above, the heating efficiency of the object and the cooling efficiency of the electrode can further be enhanced.

In this case, each of the plural tubular heaters may be a sheath heater, for example, and each of the plural cooling pipes may be a cooling gas-passing pipe, for example.

Further, it is preferable that the plural tubular heaters can individually control a heating temperature, and the plural cooling pipes can individually control a cooling temperature. When the plural tubular heaters and cooling pipes are configured as described above, the specific part of the object and the electrode can selectively be heated/cooled, for example, whereby the heating efficiency/ cooling efficiency can more be enhanced.

Specifically, the tubular heaters and the cooling pipes may be configured such that a heating performance of the tubular heaters and a cooling performance of the cooling pipes are greater at a central part of one of the electrodes and smaller at a peripheral part of the electrode. When the tubular heater and the cooling pipe are configured as described above, the heating/cooling control of the electrode can effectively be performed according to a general characteristic of the electrode in which a property to be heated is greater and the property to be cooled is smaller at the central part of the electrode, and further, a property to be heated is smaller and a property to be cooled is greater at the peripheral part of the electrode.

Alternatively, the tubular heaters and the cooling pipes may be configured such that densities of an arrangement number of the tubular heaters and the cooling pipes per unit area of the plane of one of the electrodes are greater at a central part of the electrode and smaller at a peripheral part of the electrode. When the tubular heater and the cooling pipe are configured as described above, the heating/ cooling control of the electrode can effectively be performed according to a general characteristic of the electrode in which a property to be heated is greater and the property to be cooled is smaller at the central part of the electrode, and further, a property to be heated is smaller and a property to be cooled is greater at the peripheral part of the electrode.

The tubular heaters and the cooling pipes may be configured such that U-shaped curved portions of the heaters/ the pipes direct in the same direction or in the reverse direction with respect to the adjacent heater/ the adjacent pipe. In the latter case, the U-shaped curved portions of the tubular heaters/ the cooling pipes are alternately arranged with respect to the adjacent heater/ the adjacent pipe, whereby a more uniform heating/ cooling control of the electrode can be executed.

Further, it is preferable that one of the electrodes is made of a material (e.g., stainless steel, steel, or an aluminum alloy) and the cooling pipe is made of a material (e.g., stainless steel, or steel with respect to an aluminum alloy) having a thermal conductivity lower than a thermal conductivity of the material constituting one of the electrodes. When the thermal conductivity of the material of the cooling pipe is lower than the thermal conductivity of the material constituting one of the electrodes, a rapid rise in the temperature of the cooling gas can be prevented, so that a cooling in a plane in an large-sized heater also can uniformly be performed, and hence, a heating/cooling control of the electrode can more effectively be executed.
Examples of the cooling gas to be introduced into the cooling pipe include a gas having a low thermal conductivity, for example, such as air, oxygen, nitrogen, argon, hydrogen, etc. In order to secure safety, a gas that is difficult to react with the reactive gas in the vacuum chamber is preferably selected. When the reactive gas in the vacuum chamber is a combustible gas, argon or nitrogen is preferably used.

According to another aspect of the present invention, there is provided a heating device for a plasma processing apparatus, wherein plural metal plates are laminated so as to be in contact with each other, a channel is formed on at least one of the contact surfaces of these plates, and a heating section for heating an object to be plasma-processed, and a cooling section for cooling the object are arranged in the channel.
According to still another aspect of the present invention, there is provided a plasma processing method by a plasma processing apparatus comprising a vacuum chamber in which a reaction for a plasma process is executed, and a heating device provided in the vacuum chamber for heating an object to be plasma-processed, including a first step in which the temperature of the heating device is increased to a predetermined temperature with the pressure in the vacuum chamber being maintained at a first pressure that is lower than the atmospheric pressure, without plasma-processing the object, and a second step, which is performed after the first step, and in which the pressure in the vacuum chamber is lowered to a second pressure, which is lower than the first pressure and by which the plasma process can be executed, with the temperature of the heating device, which is increased to the predetermined temperature, being kept at the temperature, and then, the heating device heats the object to perform the plasma process with the pressure in the vacuum chamber being maintained at the second pressure.

### EFFECT OF THE INVENTION

The plasma processing apparatus according to one aspect of the present invention comprises a vacuum chamber in which a reaction for a plasma process is executed, a gas introducing section for introducing a plasma processing reaction gas into the vacuum chamber, a gas exhausting section for exhausting the reaction gas from the vacuum chamber, and at least a pair of plasma processing electrodes provided so as to be opposite to each other in the vacuum chamber. The plasma processing apparatus further comprises a tubular heating section that is provided at the inside or on a surface of one of the electrodes for heating an object to be plasma-processed, and a tubular cooling section that is provided at the inside or on the surface of the electrode for cooling the electrode, wherein the heating section and the cooling section are arranged on the same plane.

Accordingly, in the plasma processing apparatus according to the present invention, there is no need to form a channel on both surfaces of one of the electrodes before the heating section and the cooling section are provided, as in the conventional case, whereby it is unnecessary to secure a certain amount of thickness of the electrode, and the manufacturing cost is relatively small. Moreover, since the heating section and the cooling section are provided on the same plane at the inside or on the surface of the electrode, a heating efficiency and a cooling efficiency are excellent.

### BRIEF DESCRPTION OF THE DRAWINGS

Fig. 1 is a schematic front view of a plasma processing apparatus in a first embodiment of the present invention.
Fig. 2 is an explanatory view of a configuration of a substrate transporting system in the plasma processing apparatus illustrated in Fig. 1.
Fig. 3 is a sectional view taken along line A-A in Fig. 2.
Fig. 4 is a plan view illustrating a certain specific part of an anode electrode that is one component of the plasma processing apparatus illustrated in Fig. 1.
Fig. 5 is a sectional view taken along line B-B in Fig. 4.
Fig. 6 is an exploded explanatory view of the anode electrode illustrated in Fig. 5.
Fig. 7 is a plan view illustrating a certain specific part of an anode electrode that is one component of a plasma processing apparatus according to a second embodiment of the present invention.
Fig. 8 is a sectional view taken along line C-C in Fig. 7.
Fig. 9 is a plan view illustrating a certain specific part of an anode electrode that is one component of a plasma processing apparatus according to a third embodiment of the present invention.
Fig. 10 is a time chart for explaining a plasma processing method in a plasma processing apparatus according to a fourth embodiment of the present invention.
Fig. 11 is a time chart for explaining a conventional general plasma processing method.

### EXPLANATION OF REFERENCE NUMERALS

1 First vacuum chamber (object carrying-in chamber)
2 Second vacuum chamber (plasma processing chamber)
3 Third vacuum chamber (object carrying-out chamber)
4 Gate valve
5 Object (tray)
6 Object (substrate)
7 Anode electrode
10 Inner channel
14 Vacuum pump
15 Object carrying-in door
16a On/off valve
16b Pressure adjusting valve
17 Object carrying-out door
18 Cathode electrode
19 Reaction gas introducing pipe
20 Leak gas introducing pipe
21 Condenser
22 Rectifying circuit
23 High-frequency power supply
31, 31' Tubular heating section (tubular heater)
32, 32' Tubular cooling section (cooling pipe)
33 Heater wiring

### BEST EMBODIMENTS FOR CARRYING OUT THE INVENTION

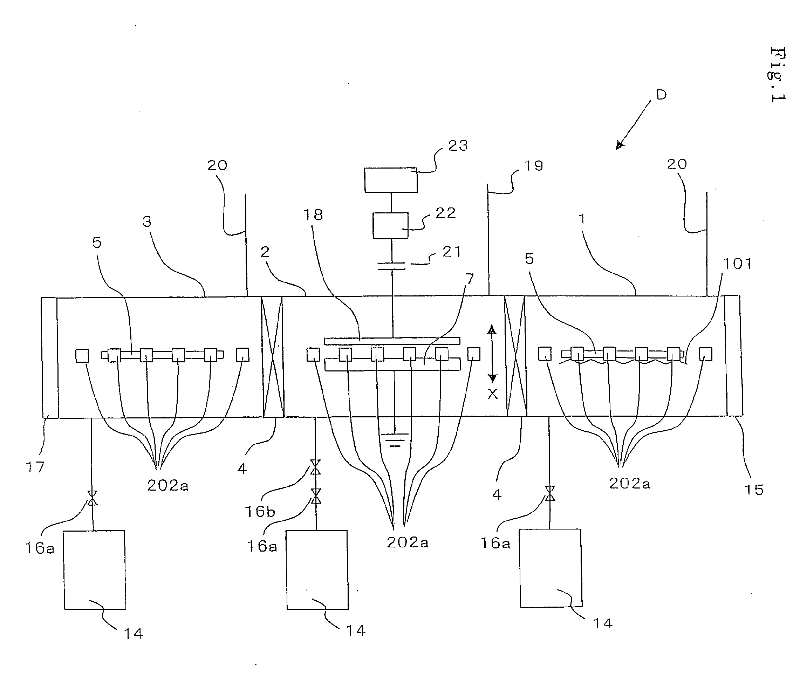

Three preferable embodiments of the present invention will be described below with reference to Figs. 1 to 9 that are attached drawings. It is to be noted that the present invention is not limited to these embodiments.

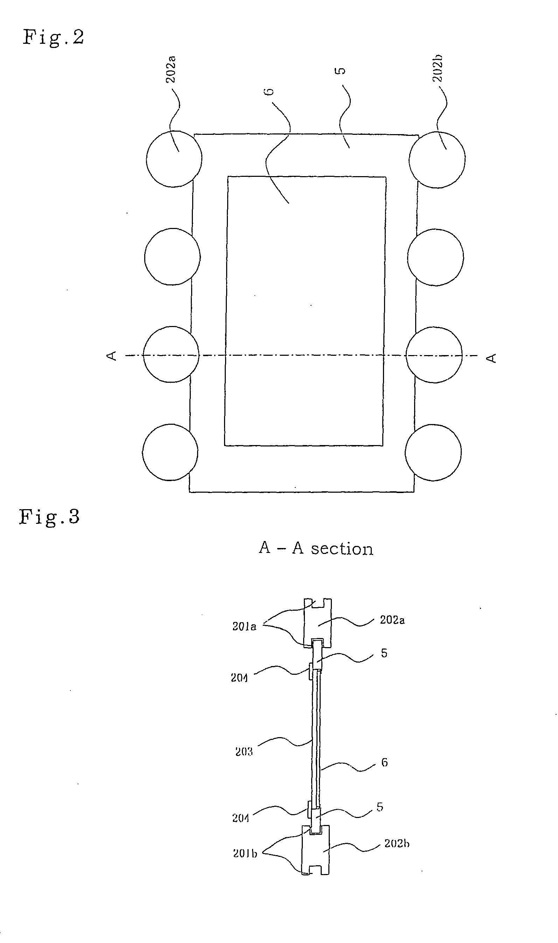

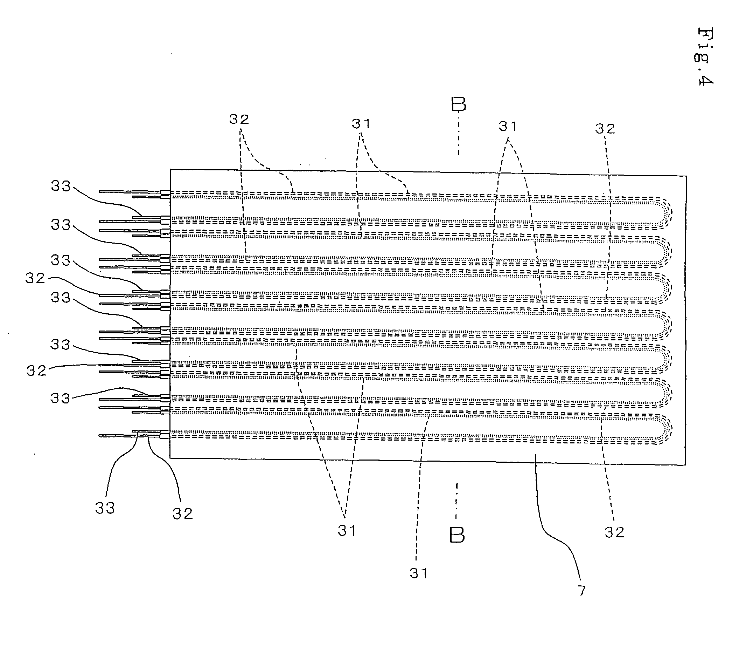

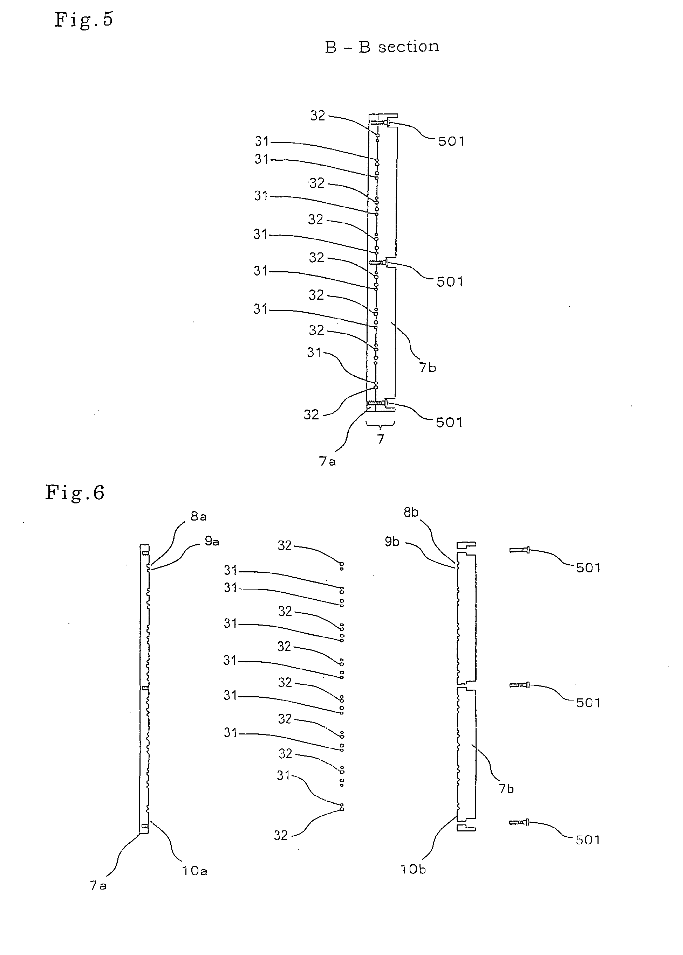

Fig. 1 is a schematic front view of a plasma processing apparatus in a first embodiment of the present invention. Fig. 2 is an explanatory view of a configuration of a substrate transporting system in the plasma processing apparatus illustrated in Fig. 1. Fig. 3 is a sectional view taken along line A-A in Fig. 2. Fig. 4 is a plan view illustrating a certain specific part of an anode electrode 7 that is one component of the plasma processing apparatus illustrated in Fig. 1. Fig. 5 is a sectional view taken along line B-B in Fig. 4. Fig. 6 is an exploded explanatory view of the anode electrode 7 illustrated in Fig. 5.

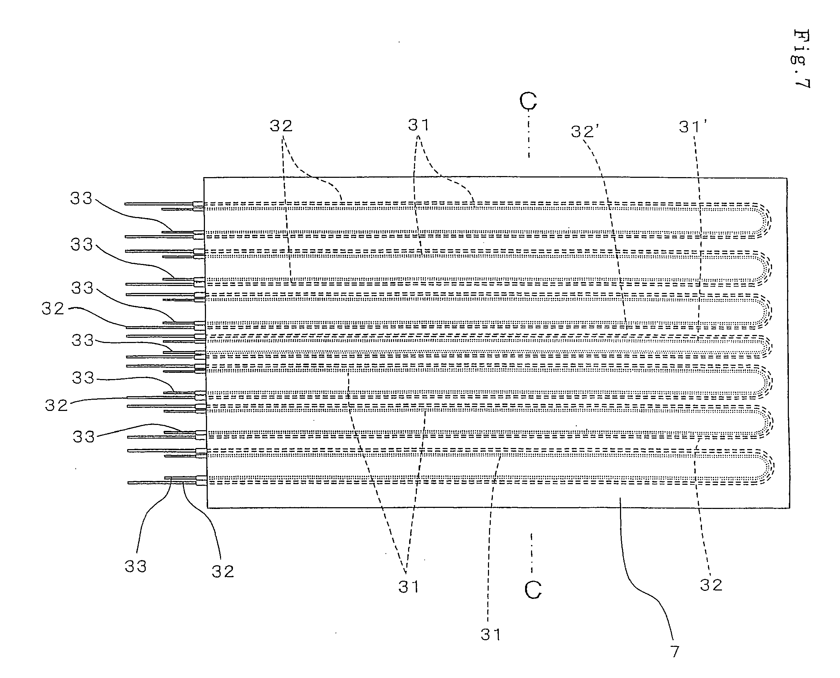

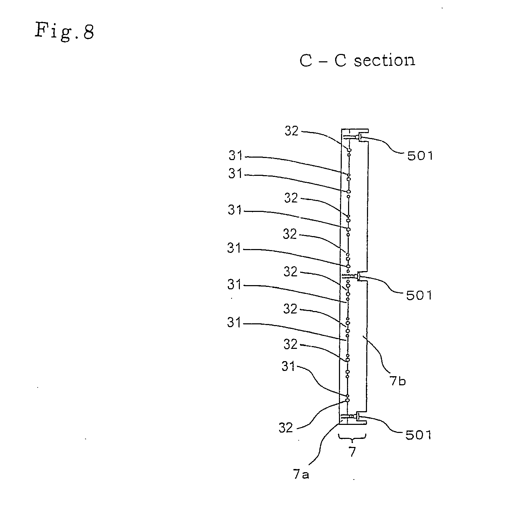

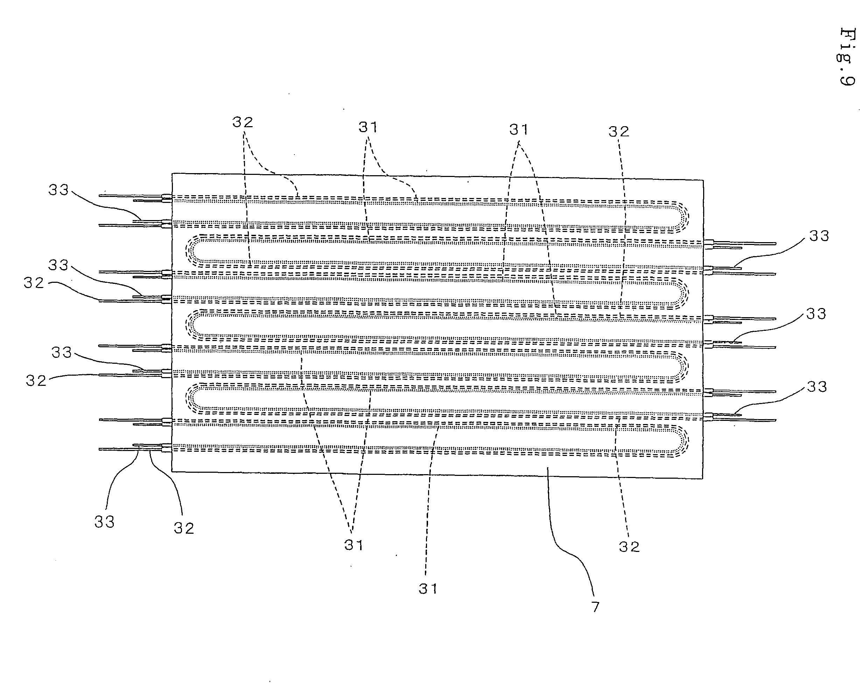

Fig. 7 is a plan view illustrating a certain specific part of an anode electrode that is one component of a plasma processing apparatus according to a second embodiment of the present invention. Fig. 8 is a sectional view taken along line C-C in Fig. 7. Fig. 9 is a plan view illustrating a certain specific part of an anode electrode that is one component of a plasma processing apparatus according to a third embodiment of the present invention.

### First Embodiment

As illustrated in Fig. 1, a plasma processing apparatus D in the first embodiment has a first vacuum chamber 1, a second vacuum chamber 2, and a third vacuum chamber 3, which are provided from an upstream side toward a downstream side in a transporting direction so as to be adjacent to each other. These three vacuum chambers 1 to 3 are configured such that one casing linearly extending in a longitudinal direction is divided into three sections by two partitioning gate valves 4, 4 that can be opened and closed. Three vacuum chambers 1 to 3 are made of stainless steel, wherein a mirror finish is performed on their inner surfaces. The gate valves 4, 4 are configured to be capable of being opened and closed, wherein they can communicate or separate the adjacent two vacuum chambers 1 and 2, or 2 and 3 to each other or from each other.

The first vacuum chamber 1 is defined as an object carrying-in chamber for carrying in a plate-like object (here, a tray 5 and a plasma processing substrate 6 placed onto the tray 5). The first vacuum chamber 1 is provided with a heater 101 for heating the plasma processing substrate 6. The second vacuum chamber 2 is defined as a plasma processing chamber that is connected to the object carrying-in chamber 1 for performing a plasma process to the object. The third vacuum chamber 3 is defined as an object carrying-out chamber that is connected to the plasma processing chamber 2 for carrying out the object.

As illustrated in Figs. 2 and 3, the object carrying-in chamber 1, the plasma processing chamber 2, and the object carrying-out chamber 3 are respectively provided with rollers 202a and 202b for transporting the tray 5 having the plasma processing substrate 6 mounted thereon. The tray 5 is arranged between a channel 201a of the roller 202a located at the upper part and a channel 201b of the roller 202b located at the lower part, whereby the tray 5 is transported with the rotation of the rollers 202a and 202b. A back plate 203 made of a metal or a carbon is provided at the back side of the plasma processing substrate 6, and it is fixed by a fixing member 204 from the back side of the tray 5.

The object carrying-in chamber 1, the plasma processing chamber 2, and the object carrying-out chamber 3 are respectively connected to external vacuum pumps 14, 14, 14 through on-off valves 16a in order to evacuate the chambers. An object carrying-in door 15 is provided at an inlet of the object carrying-in chamber 1. The plasma processing chamber 2 is connected to the vacuum pump 14 via a pressure adjusting valve 16b, and to a reaction gas introducing pipe 19 that introduces a plasma processing reaction gas. An object carrying-out door 17 is provided at an outlet of the object carrying-out chamber 3. Further, the object carrying-in chamber 1 and the object carrying-out chamber 3 are respectively connected to leak gas introducing pipes 20, 20.

An anode electrode 7 is provided in the plasma processing chamber 2. The anode electrode 7 and the tray 5 are electrically connected, and the anode electrode 7 and the tray 5 are electrically grounded. For example, the anode electrode 7 and the tray 5 may be electrically connected via the rollers 202a and 202b. Further, preferably, a contact member having electric conductivity, thermal conductivity, and flexibility such as a plate spring or a metal brush may be provided on the surface of the anode electrode 7 that is opposite to the tray 5, in order to bring the anode electrode 7 into electrical contact with the tray 5. A metal material is preferable for the material of the contact member. It is preferable from the viewpoint of controlling a temperature of the substrate that the tray 5 and the plasma processing substrate 6, which are the objects, and the electrode (in the present embodiment, the anode electrode 7) provided with a heater serving as a heating section and a cooling pipe serving as a cooling section are brought into contact with each other with a greater contact area. In this case, the anode electrode 7 has a function of a plate-like heating device for performing a temperature control (heating/cooling) of the object.

In addition to the configuration described above, the rollers 202a and 202b may be configured to be movable in a direction X (see Fig. 1) in which the tray 5 and the anode electrode 7 oppose to each other. In the configuration described above, after the tray 5 and the plasma processing substrate 6 are transported to the plasma processing chamber 2, the rollers 202a and 202b in the plasma processing chamber 2 are moved to be capable of pushing the tray 5, which is a part of the object, against the anode electrode 7. With this configuration, the contact area increases, whereby the precision in the temperature control of the object can further be enhanced.

It may be configured such that the surface of the opposed electrode on which the substrate is placed is arranged in a horizontal direction, and the plasma processing substrate 6 is directly placed on the anode electrode 7 provided with the heating section and the cooling section. This case is also preferable from the viewpoint of the temperature control of the substrate since the contact area between the plasma processing substrate 6, which is the object, and the anode electrode 7 increases.

A plasma processing cathode electrode 18 is provided at the position opposite to the anode electrode 7 in the plasma processing chamber 2. The cathode electrode 18 is electrically connected to a high-frequency power supply 23 through a condenser 21 and a rectifying circuit 22 at the outside of the plasma processing chamber 2.

As illustrated in Figs. 4 and 5, the anode electrode 7 further has provided thereto tubular heating sections 31, ..., 31 for heating the object (including the tray 5 and the plasma processing substrate 6 mounted on the tray 5) that is to be plasma-processed. The tubular heating sections 31, ..., 31 include seven tubular heaters (here, a sheath heater) 31, ..., 31 that are U-shaped in plan configuration, and are arranged to be adjacent to each other in parallel.

Tubular cooling sections 32, ..., 32 for cooling the anode electrode 7 are also provided in the anode electrode 7. The cooling sections 32, ..., 32 include seven cooling pipes (here, a cooling nitrogen gas-passing pipe) 32, ..., 32 that are U-shaped in plan configuration , are arranged to be adjacent to each other in parallel along the outer side of the corresponding tubular heater 31, ..., 31, and can exhaust a cooling gas, which is introduced into the inside and passes through the cooling pipes, to the outside. These cooling pipes 32, ..., 32 can be made of a material same as the material (here, an aluminum alloy) constituting the anode electrode 7, and it is desirably made of a material (here, stainless steel) having a thermal conductivity lower than that of the material constituting the anode electrode 7.

These tubular heaters 31, ..., 31 and the cooling pipes 32, ..., 32 are provided on the same plane in the anode electrode 7. Each of the tubular heaters 31 is connected to a heater wiring 33. Moreover, these tubular heaters 31, ..., 31 can individually control a heating temperature, while these cooling pipes 32, ..., 32 can individually control a cooling temperature.

Since the tubular heaters 31, ..., 31 and the cooling pipes 32, ..., 32 are configured as described above, the specific parts of the tray 5 and the substrate 6, which are the objects, and the anode electrode 7 can selectively be heated/cooled, whereby the heating efficiency of the tray 5 and the substrate 6 and the cooling efficiency of the anode electrode 7 can further be enhanced.

A configuration and a manufacturing method of the anode electrode 7 will be described with reference to Figs. 5 and 6. The anode electrode 7 has a structure in which two plates 7a and 7b are laminated. The object is placed onto one plate 7a (the plate located at the upper position, and having a thickness smaller than that of the other plate 7b) to be subject to a temperature control. Channels 8a and 8b into which the cooling pipes 32 are fitted and channels 9a and 9b into which the tubular heaters 31 are fitted are formed on opposite surfaces 10a and 10b of these plates 7a and 7b. The planar shape of each of the channels 8a, 8b, 9a, and 9b viewed from the opposite surfaces 10a and 10b is a U-shape as illustrated in Fig. 4. The sectional shape of the channels 8a and 8b may be the one by which the tubular heaters 31 can be brought into contact with the channels 8a and 8b, while the sectional shape of the channels 9a and 9b may be the one by which the cooling pipes 32 can be brought into contact with the channels 9a and 9b. In the present embodiment, the tubular heaters 31 and the cooling pipes 32 have a circular sectional shape, and the sectional shapes of the channels 8a, 8b, 9a, and 9b are formed to be arc in order that the channels can be brought into contact with the tubular heaters 31 and the cooling pipes 32. The plates 7a and 7b can be formed integral with each other by a caulking with a cold rolling or a screwing. In the present embodiment, they are screwed by screws 501 to be bonded, whereby the anode electrode 7 is produced.

Since the anode electrode 7 according to the present invention has to have the plural pipes (the tubular heaters 31 and the cooling pipes 32) arranged therein, the internal processing is complicated. However, as described above, the anode electrode 7 is divided in a thickness direction, and the plural pipes are sandwiched, with the result that it can be produced with relative ease.

### Second Embodiment

As illustrated in Figs. 7 and 8, in a plasma processing apparatus in a second embodiment, tubular heating sections 31, ..., 31', ..., 31 for heating the object (the tray 5 and the substrate 6) to be plasma-processed are provided in the anode electrode 7. The tubular heating sections 31, ... 31', ..., 31 include seven tubular heaters (here, a sheath heater) 31, ... 31', ..., 31 that are U-shaped in plan configuration, and are arranged to be adjacent to each other in parallel.
It is to be noted that one tubular heater 31' at the central part has a width of a U-shape narrower than those of the other six tubular heaters 31, ..., 31 at the peripheral part. It is preferable that the heater capacity of the central heater 31' is set to be smaller than those of the peripheral heaters 31 in order that the in-plane distribution of a flat-plate heater is not biased too much toward the center.
Specifically, it is preferable that the heater capacity (thermal capacity) of the heater 31' at the central part of the anode electrode 7 is set to be smaller than those of the heaters 31 at the peripheral part of the anode electrode 7, and it is more preferable that the heater capacity (thermal capacity) is stepwisely decreased from the peripheral part toward the central part.
The heat of the anode electrode 7 generally tends to be emitted more from the peripheral part, and therefore, if the thermal capacity of the central heater is set to be equal to those of the peripheral heaters, the temperature at the central part of the anode electrode is liable to increase. On the other hand, when the thermal capacity of the central heater 31' is set to be smaller than those of the peripheral heaters 31, an advantage is brought about in which a uniformity in the temperature of the anode electrode 7 in the plane of the anode electrode 7 is improved.

Tubular cooling pipes 32, ... , 32', ... , 32 for cooling the anode electrode 7 are also provided in the anode electrode 7. The cooling sections 32, ..., 32', ..., 32 include seven cooling pipes (here, a cooling nitrogen gas-passing pipe) 32, ..., 32', ..., 32 that are U-shaped in plan configuration , are arranged to be adjacent to each other in parallel along the outer side of the corresponding tubular heater 31, ..., 31', ... , 31, and can exhaust a cooling gas, which is introduced into the inside and passes through the cooling pipes, to the outside. It is to be noted that one cooling pipe 32' at the central part has a width of a U-shape narrower than those of the other six cooling pipes 32, ..., 32 at the peripheral part.

The configurations of the other parts in the plasma processing apparatus according to the second embodiment are the same as those of the corresponding parts in the plasma processing apparatus D in the first embodiment.

As described above, the tubular heaters 31, ..., 31', ..., 31 and the cooling pipes 32, ..., 32', ..., 32 are configured such that a density of an arrangement number of the tubular heaters and the cooling pipes per unit area of the plane of the anode electrode 7 is set to be greater at the central part of the anode electrode 7 and smaller at the peripheral part of the anode electrode 7.

Since the tubular heaters 31, ..., 31', ..., 31 and the cooling pipes 32, ..., 32', ..., 32 are configured as described above, the heating/cooling control of the anode electrode 7 can effectively be performed according to a general characteristic of the anode electrode 7 in which a property to be heated is greater and the property to be cooled is smaller at the central part of the anode electrode 7, and further, a property to be heated is smaller and a property to be cooled is greater at the peripheral part of the anode electrode 7.

In the present embodiment, an example of changing the density of the cooling pipes in the plane is illustrated. However, in the arrangement of the cooling pipes in the first embodiment, a tube diameter may be set to be greater only at the central part, or a tube diameter may be stepwisely changed. With this configuration, the cooling efficiency at the central part can be enhanced.

### Third Embodiment

As illustrated in Fig. 9, in a plasma processing apparatus in the third embodiment, tubular heating sections 31, ..., 31 for heating the object (the tray 5 and the substrate 6) that is to be plasma-processed are provided in the anode electrode 7. The tubular heating sections 31, ..., 31 include seven tubular heaters (here, a sheath heater) 31, ... , 31 that are U-shaped in plan configuration, and are arranged to be adjacent to each other in parallel. It is to be noted that the tubular heaters 31, ..., 31 are arranged such that the adjacent tubular heaters 31, ..., 31 are provided in such a manner that the U-shaped curved portions of the heaters 31, ..., 31 direct in the reverse direction.

Tubular cooling pipes 32, ..., 32 for cooling the anode electrode 7 are also provided in the anode electrode 7. The tubular cooling sections 32, ..., 32 include seven cooling pipes (here, a cooling nitrogen gas-passing pipe) 32, ..., 32 that are U-shaped in plan configuration , are arranged to be adjacent to each other in parallel along the outer side of the corresponding tubular heater 31, ..., 31 and can exhaust a cooling gas, which is introduced into the inside and passes through the cooling pipes, to the outside. It is to be noted that the cooling pipes 32, ..., 32 are arranged such that the adjacent tubular cooling pipes 32, ..., 32 are provided in such a manner that the U-shaped curved portions of the heaters direct in the reverse direction.

The configurations of the other parts in the plasma processing apparatus according to the third embodiment are the same as those of the corresponding parts in the plasma processing apparatus D in the first embodiment.

As described above, the tubular heaters 31, ..., 31 and the cooling pipes 32, ..., 32 are arranged such that the adjacent tubular heaters 31, ..., 31 and the cooling pipes 32, ..., 32 are provided in such a manner that the U-shaped curved portions of the heaters direct in the reverse direction. Therefore, the U-shaped curved portions of the tubular heaters 31, ..., 31 and the cooling pipes 32, ..., 32 are alternately arranged with respect to the adjacent tubular heaters 31, ..., 31 and the cooling pipes 32, ..., 32, whereby a more uniform heating/cooling control of the anode electrode 7 can be performed.

### Fourth Embodiment

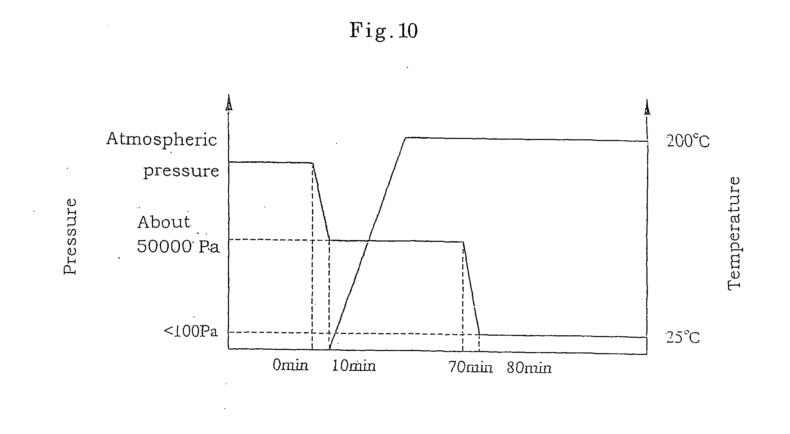

Although not illustrated in the figure, a plasma processing apparatus according to the fourth embodiment of the present invention includes a vacuum chamber in which a reaction for a plasma process is performed, and a heating device that heats an object to be plasma-processed in the vacuum chamber. Fig. 10 is a time chart for explaining a plasma processing method by the plasma processing apparatus according to the fourth embodiment of the present invention. An axis of abscissa of this time chart indicates an elapsed time of the plasma process by the plasma processing apparatus, while an axis of ordinate indicates a pressure (left) and a temperature (right) in the vacuum chamber of the plasma processing apparatus.

The plasma processing method by the plasma processing apparatus according to the fourth embodiment includes a first step in which the temperature of the heating device is increased to a predetermined temperature with the pressure in the vacuum chamber being maintained at a first pressure that is lower than the atmospheric pressure, without plasma-processing the object, and a second step, which is performed after the first step, and in which the pressure in the vacuum chamber is lowered to a second pressure, which is lower than the first pressure and by which the plasma process can be executed, with the temperature of the heating device, which is increased to the predetermined temperature, being kept at the temperature, and then, the heating device heats the object to perform the plasma process with the pressure in the vacuum chamber being maintained at the second pressure.

This plasma processing method will specifically be described with reference to Fig. 10.
Firstly, the vacuum chamber, which is exposed to air, is closed (time "0 min"). Then, the pressure in the vacuum chamber is lowered to the first pressure (low-vacuum state having "about 50000 Pa (Pascal)") that is lower than the atmospheric pressure for 10 minutes (time "10 min"), without plasma-processing the object. At this time, the temperature of the object is 25°C that is the temperature in the vacuum chamber.
Then, the pressure in the vacuum chamber is kept at the first pressure, and the temperature of the heating device is increased to 200°C, which is a predetermined heating temperature for the plasma process, for about 30 minutes.
Then, it is confirmed that the heating device is maintained at 200°C (time "70 min"). Subsequently, the pressure in the vacuum chamber is lowered to the second pressure ("less than 100 Pa", for example, a high-vacuum state having 50 Pa), which is lower than the first pressure and by which the plasma process can be executed, for 10 minutes (time "80 min").
Thereafter, the object is heated by the heating device with the vacuum chamber being maintained to have the second pressure, whereby the object is plasma-processed.

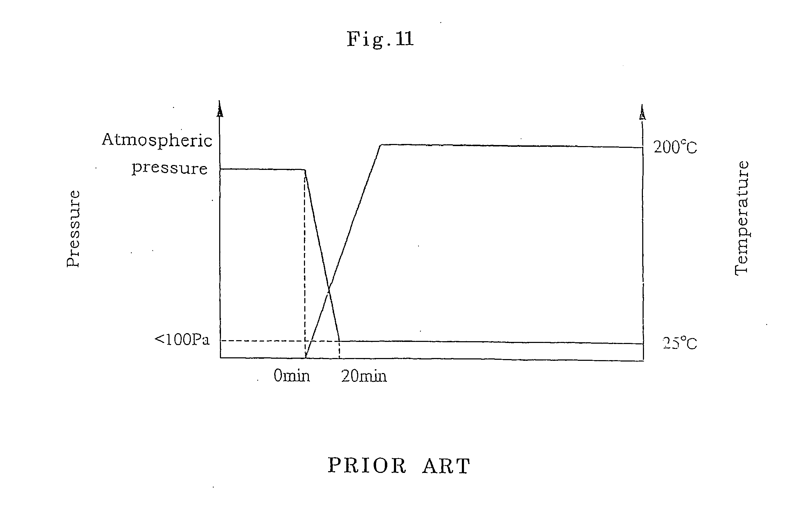

Fig. 11 is a time chart for explaining a conventional general plasma processing method. An axis of abscissa and an axis of ordinate of this time chart are the same as those in the time chart illustrated in Fig. 10.

In the conventional general plasma processing method illustrated in Fig. 11, the vacuum chamber that is exposed to air is closed (time "0 min").
Then, the pressure in the vacuum chamber is lowered from the atmospheric pressure to a predetermined pressure (high-vacuum state of "less than 100 Pa"), which is lower than the atmospheric pressure and by which the plasma process can be performed, for a predetermined time (e.g., 20 minutes) (time "20 min").
Simultaneously with this process, the temperature of the heating device for heating the object is increased to 200°C, which is a predetermined heating temperature for the plasma process, for a predetermined time (e.g., about 60 minutes). Next, it is confirmed that the heating device is kept to have 200°C.
Thereafter, the heating device heats the object with the vacuum chamber being kept to have the predetermined pressure, whereby the object is plasma-processed.

In the conventional general plasma processing method described above, the temperature of the heating device is increased in the high-vacuum state that is the predetermined pressure. Therefore, since the thermal conductivity due to a plasma processing reaction gas around the heating device is low, a thermal distribution of components in the heating device is increased to produce a distortion on the components, resulting in that the heating device might be deformed.

The plasma processing method according to the present invention illustrated in Fig. 10 includes a first step in which the temperature of the heating device is increased to a predetermined temperature with the pressure in the vacuum chamber being maintained at a first pressure that is lower than the atmospheric pressure, without plasma-processing the object, and a second step, which is performed after the first step, and in which the pressure in the vacuum chamber is lowered to a second pressure, which is lower than the first pressure and by which the plasma process can be executed, with the temperature of the heating device, which is increased to the predetermined temperature, being kept at the temperature, and then, the heating device heats the object to perform the plasma process with the pressure in the vacuum chamber being maintained at the second pressure.
Therefore, a thermal conductivity due to a plasma processing reaction gas around the heating device is increased to gently rise the temperature of the heating device, whereby the fear of the deformation of the heating device can be prevented.

## Claims

1. A plasma processing apparatus comprising a vacuum chamber in which a reaction for a plasma process is executed, a gas introducing section for introducing a plasma processing reaction gas into the vacuum chamber, a gas exhausting section for exhausting the reaction gas from the vacuum chamber, and at least a pair of plasma processing electrodes provided so as to be opposite to each other in the vacuum chamber, the plasma processing apparatus further comprising:
a tubular heating section that is provided at an inside or on a surface of one of the electrodes for heating an object, which is to be plasma-processed, and a tubular cooling section that is provided at the inside or on the surface of the electrode for cooling the electrode, wherein the heating section and the cooling section are arranged on the same plane.

2. The plasma processing apparatus according to claim 1, wherein
the heating section includes plural tubular heaters that are U-shaped in plan configuration, and are arranged to be adjacent to each other in parallel, and the cooling section includes plural tubular cooling pipes that are U-shaped in plan configuration, are arranged to be adjacent to each other in parallel along the outer side or the inner side of the corresponding tubular heaters, and can exhaust a cooling gas, which is introduced into the inside and passes through the cooling pipes, to the outside.

3. The plasma processing apparatus according to claim 2, wherein
each of the plural tubular heaters is a sheath heater, and each of the plural cooling pipes is a cooling gas-passing pipe.

4. The plasma processing apparatus according to claim 2, wherein
the plural tubular heaters can individually control a heating temperature, and the plural cooling pipes can individually control a cooling temperature.

5. The plasma processing apparatus according to claim 2, wherein
the tubular heaters and the cooling pipes are configured such that a heating performance of the tubular heaters and a cooling performance of the cooling pipes are greater at a central part of one of the electrodes and smaller at a peripheral part of the electrode.

6. The plasma processing apparatus according to claim 2, wherein
the tubular heaters and the cooling pipes are configured such that densities of an arrangement number of the tubular heaters and the cooling pipes per unit area of the plane of one of the electrodes are greater at a central part of the electrode and smaller at a peripheral part of the electrode.

7. The plasma processing apparatus according to claim 2, wherein
the tubular heaters and the cooling pipes are arranged such that U-shaped curved portions of the heaters and the pipes direct in the reverse direction with respect to the adjacent heater and the adjacent pipe.

8. The plasma processing apparatus according to claim 2, wherein
the cooling pipe is made of a material having a thermal conductivity lower than that of the material constituting one of the electrodes.

9. The plasma processing apparatus according to claim 2, wherein
the plural tubular heaters are provided from a central part to a peripheral part of one of the electrodes, and configured such that a thermal capacity of the tubular heater at the central part is smaller than the thermal capacity of the tubular heater at the peripheral part.

10. A heating device for a plasma processing apparatus, wherein plural metal plates are laminated so as to be in contact with each other, a channel is formed on at least one of the contact surfaces of these plates, and a heating section for heating an object to be plasma-processed, and a cooling section for cooling the object are arranged in the channel.

11. The heating device according to claim 10, wherein
the channel is formed on the plate, with which the object is brought into contact, of the plural plates.

12. The heating device according to claim 10 or claim 11, wherein
the channel is formed on the respective contact surfaces of two plates, which are in contact with each other, so as to make a pair, and the heating section and the cooling section are interposed in the channels that are formed so as to make a pair.

13. The heating device according to claim 12, wherein
the sectional shapes of the paired channels are the same as the sectional shape of the heating section and the sectional shape of the cooling section.

14. The heating device according to any one of claims 11 to 13, wherein
the plural plates are formed in such a manner that the plate with which the object is in contact is set to have the smallest thickness.

15. The heating device according to any one of claims 10 to 14, wherein
the heating section and the cooling section are provided on the same plane.

16. A plasma processing apparatus comprising a vacuum chamber in which a reaction for a plasma process is executed, a gas introducing section for introducing a plasma processing reaction gas into the vacuum chamber, a gas exhausting section for exhausting the reaction gas from the vacuum chamber, and at least a pair of plasma processing electrodes provided so as to be opposite to each other in the vacuum chamber, wherein
the heating device according to any one of claims 10 to 15 serves as a part of the plasma processing electrode.

17. A plasma processing method by a plasma processing apparatus comprising a vacuum chamber in which a reaction for a plasma process is executed, and a heating device provided in the vacuum chamber for heating an object to be plasma-processed, including:
a first step in which the temperature of the heating device is increased to a predetermined temperature with the pressure in the vacuum chamber being maintained at a first pressure that is lower than the atmospheric pressure, without plasma-processing the object, and
a second step, which is performed after the first step, and in which the pressure in the vacuum chamber is lowered to a second pressure, which is lower than the first pressure and by which the plasma process can be executed, with the temperature of the heating device, which is increased to the predetermined temperature, being kept at the temperature, and then, the heating device heats the object to perform the plasma process with the pressure in the vacuum chamber being maintained at the second pressure.

18. The plasma processing method according to claim 17, wherein
the first pressure is 5000 to 80000 pascals, and the second pressure is 10 to 100 pascals.
